(19) Europäisches Patentamt
European Patent Office
Office européen des brevets

(11) EP 1 708 547 A1

(12) **EUROPEAN PATENT APPLICATION**
published in accordance with Art. 158(3) EPC

(43) Date of publication:
**04.10.2006 Bulletin 2006/40**

(21) Application number: **05703759.0**

(22) Date of filing: **18.01.2005**

(51) Int Cl.:
***H05B 33/14*** *(2006.01)* ***C09K 11/06*** *(2006.01)*

(86) International application number:
**PCT/JP2005/000522**

(87) International publication number:
**WO 2005/072017 (04.08.2005 Gazette 2005/31)**

(84) Designated Contracting States:
**AT BE BG CH CY CZ DE DK EE ES FI FR GB GR HU IE IS IT LI LT LU MC NL PL PT RO SE SI SK TR**

(30) Priority: **21.01.2004 JP 2004012630**

(71) Applicant: **IDEMITSU KOSAN CO., LTD.**
**Tokyo 100-8321 (JP)**

(72) Inventors:
- **NAKAMURA, Hiroaki**
  **2990293 (JP)**
- **ARAKANE, Takashi**
  **2990293 (JP)**
- **IWAKUMA, Toshihiro**
  **2990293 (JP)**
- **IKEDA, Kiyoshi**
  **2990293 (JP)**
- **IKEDA, Hidetsugu**
  **2990293 (JP)**
- **KUBOTA, Mineyuki**
  **2990293 (JP)**

(74) Representative: **Gille Hrabal Struck Neidlein Prop Roos**
**Brucknerstrasse 20**
**40593 Düsseldorf (DE)**

# (54) HOST MATERIAL FOR ORGANIC ELECTROLUMINESCENT ELEMENT AND ORGANIC ELECTROLUMINESCENT ELEMENT

(57) A compound for obtaining an organic electroluminescence device having a long life of light emission and exhibiting excellent heat resistance is provided. The compound is a host material for organic electroluminescence devices comprising a carbazole derivative represented by the following general formula [I]. In general formula [I], one of $R^1$ and $R^2$ represents a group expressed by the following formula [II], and the other represents the group expressed by formula [II], hydrogen atom or an aryl group having 6 to 50 nuclear carbon atoms. Ar represents a substituted or unsubstituted aryl group having 6 to 60 nuclear carbon atoms, a case where Ar represents phenyl group, 4-biphenyl group, 4-terphenyl group or 4-quaterphenyl group is excluded and, when $R^1$ represents hydrogen atom and $R^2$ represents the group expressed by formula [II], a case where Ar represents 3,5-diphenylphenyl group is excluded.

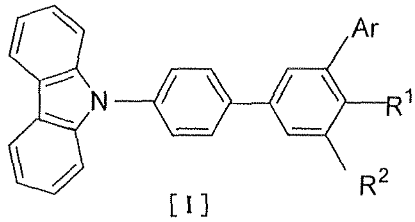

[ I ]

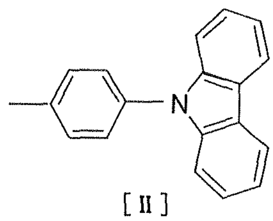

[ II ]

EP 1 708 547 A1

Printed by Jouve, 75001 PARIS (FR)

## Description

### TECHNICAL FIELD

The present invention relates to a host material for organic electroluminescent elements ("electroluminescent element" will be referred to as "EL device", hereinafter) and an organic EL device in which an organic light emitting layer comprises the host material.

### BACKGROUND ART

Organic EL devices having an organic light emitting layer disposed between electrodes have heretofore been intensively studied and developed due to the following reasons:

(1) Since the devices are completely solid devices, handling and production are easy.
(2) Since spontaneous light emission is possible, no portion for supplying light is required.
(3) Since visibility is excellent, the devices are advantageously used for displays.
(4) Full color display can be easily made.

The mechanism of light emission by the organic EL device utilizes, in general, the phenomenon of emission of fluorescent light (the luminescence phenomenon), which is the energy conversion taking place when fluorescent molecules in the singlet excited state (occasionally, referred to as the S1 state) in an organic light emitting medium make the radiative transition into the ground state. In the organic light emitting medium, the presence of fluorescent molecules in the triplet excited state (occasionally, referred to as the T1 state) is also considered. However, the radiative transition into the ground state is a forbidden transition, and the above fluorescent molecules in the triplet excited state make transition slowly into other states in accordance with a non-radiative transition. As the result, discharge of heat energy takes place in place of emission of fluorescent light.

The singlet state and the triplet state mean the states of multiplicity of energy decided by the combination of the total spin angular moment and the total orbital angular moment of the fluorescent molecule. The singlet state is defined as the energy state obtained by the transition of one electron from the ground state having no unpaired electrons to a higher energy state while the spin condition of the electron is kept unchanged. The triplet state is defined as the energy state obtained by the transition of one electron from the ground state to a higher energy state while the spin condition of the electron is reversed. The light emission from the triplet state defined above can be observed at a very low temperature such as the temperature of liquid nitrogen (-196°C). However, this temperature condition is not suitable for practical applications, and the amount of the emitted light is very small.

The total efficiency of light emission by conventional organic EL devices is related to the efficiency of recombination of injected charge carriers (electrons and holes) (ϕrec) and the probability of the radiative transition of the formed excimers (ϕrad). Therefore, the total efficiency of light emission (ϕel) of an organic EL device is expressed by the following equation:

$$\phi el = \phi rec \times 0.25 \phi rad$$

In the above equation, the coefficient 0.25 is decided by assuming that the probability of formation of the singlet excimer is 1/4. Therefore, the theoretical maximum value of the efficiency of light emission of an organic EL device is 25% even when the recombination and the radiative decay of the excimers take place at the probability coefficient of 1. The maximum value of the efficiency of light emission by conventional organic EL devices is small due to the fact that the triplet state cannot be utilized substantially and the radiative transition takes place with the singlet excimer alone as described above. It is attempted that, utilizing the triplet excimer (the species excited to the triplet state) of an organic light emitting material (a host material), the energy is transferred from the formed triplet excimer to a phosphorescent dopant so that the fluorescent light emission is obtained at the room temperature (for example, refer to Non-Patent Reference 1). More specifically, it is reported that the phosphorescence phenomenon takes place when an organic EL device having an organic light emitting layer composed of 4,4-N,N-dicarbazolylbiphenyl and an Ir complex compound as the phosphorescent dopant is formed.

However, the property of the organic EL device described in the above Non-patent Reference 1 has a half life shorter than 150 hours and is insufficient for practical applications. To overcome the problem, it is proposed that a carbazole derivative having a glass transition temperature of 110°C or higher is used as the host material (for example, refer to Patent Reference 1). However, when the examples in the reference are examined, it is found that the half life is

insufficient, and the heat resistance is poor as shown by a storage period of 200 hours at 85°C. The above technology does not achieve the property required for practical applications.

[Patent Reference 1] International Patent Application Laid-Open No. WO 01/072927
[Non-Patent Reference 1] Jpn. J. Appl. Phys., 38(1999) L1502

DISCLOSURE OF THE INVENTION

The present invention has been made under the above circumstances and has an object of providing a host material for obtaining an excellent organic EL device which can effectively emit light utilizing the triplet excited state, has a long life of light emission and exhibits excellent heat resistance.

As the result of intensive studies by the present inventors to achieve the above object, it was found that an organic EL device having a long life and exhibiting excellent heat resistance could be prepared when a specific carbazole derivative was used as the host material. It was also found that the organic EL device could utilize the triplet excited state of the host material even at the room temperature, has a life period sufficient for practical applications, exhibits excellent heat resistance and therefore could be satisfactorily used in various applications of organic EL devices including those to automobiles. It was found that, since the energy of the triplet excited state of the above carbazole derivative was sufficiently great, the energy was sufficiently transferred to the phosphorescent dopant, and the efficiency of light emission could be increased. The present invention has been completed based on the above knowledge.

The present invention provides a host material for electroluminescence devices which comprises a carbazole derivative represented by following general formula [1]:

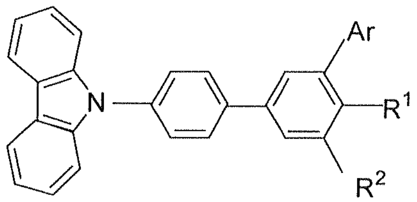

[ I ]

wherein one of $R^1$ and $R^2$ represents a group expressed by following formula [II]:

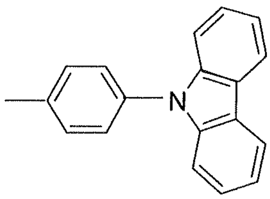

[ II ]

the other of $R^1$ and $R^2$ represents the group expressed by formula [II], hydrogen atom or an aryl group having 6 to 50 nuclear carbon atoms, Ar represents a substituted or unsubstituted aryl group having 6 to 60 nuclear carbon atoms, a case where Ar represents phenyl group, 4-biphenyl group, 4-terphenyl group or 4-quaterphenyl group is excluded and, when $R^1$ represents hydrogen atom and $R^2$ represents the group expressed by formula [II], a case where Ar represents 3,5-diphenylphenyl group is excluded.

The present invention further provides an organic EL device which comprises a cathode, an anode and an organic thin film layer which comprises at least one layer comprising at least an organic light emitting layer and is disposed between the cathode and the anode, wherein the organic light emitting layer comprises the host material described above and a dopant.

An organic EL device having a long life of light emission and exhibiting excellent heat resistance can be obtained according the present invention.

THE MOST PREFERRED EMBODIMENT TO CARRY OUT THE INVENTION

The host material of the present invention comprises a carbazole derivative represented by the following general formula [I]:

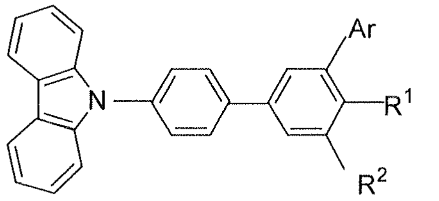

[ I ]

wherein one of $R^1$ and $R^2$ represents a group expressed by following formula [II]:

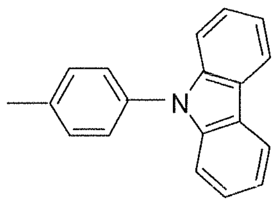

[ II ]

the other of $R^1$ and $R^2$ represents the group expressed by formula [II], hydrogen atom or an aryl group having 6 to 50 nuclear carbon atoms, Ar represents a substituted or unsubstituted aryl group having 6 to 60 nuclear carbon atoms, a case where Ar represents phenyl group, 4-biphenyl group, 4-terphenyl group or 4-quaterphenyl group is excluded and, when $R^1$ represents hydrogen atom and $R^2$ represents the group expressed by formula [II], a case where Ar represents 3,5-diphenylphenyl group is excluded.

In general formula [I], examples of the unsubstituted aryl group having 6 to 60 nuclear carbon atoms which is represented by Ar include groups having condensed rings such as naphthyl group, anthranyl group, phenanthryl group, pyrenyl group and coronyl group. Groups having condensed 2 to 4 benzene rings are preferable. The examples of the aryl group also include groups in which 2 to 10 benzene rings are connected to each other such as biphenyl group and terphenyl group.

Examples of the preferable substituent to the substituted aryl group having 6 to 60 nuclear carbon atoms which is represented by Ar include alkyl groups having 1 to 6 carbon atoms (such as ethyl group, methyl group, i-propyl group, n-propyl group, s-butyl group, t-butyl group, pentyl group, hexyl group, cyclopentyl group and cyclohexyl group), alkoxyl groups (such as ethoxyl group, methoxyl group, i-propoxyl group, n-propoxyl group, s-butoxyl group, t-butoxyl group, pentoxyl group, hexyloxyl group, cyclopentoxyl group and cyclohexyloxyl group), aryl groups having 5 to 50 nuclear atoms, amino groups substituted with aryl groups having 5 to 50 nuclear atoms, ester groups having aryl groups having 5 to 50 nuclear atoms, ester groups having alkyl groups having 1 to 6 carbon atoms, cyano group, nitro group and halogen atoms.

Since the efficiency of light emission is decreased when Ar represents a group in which benzene rings are linearly connected at the para-positions such as 4-biphenyl group, 4-terphenyl group and 4-quaterphenyl group, this case is excluded in the present invention. When $R^1$ represents hydrogen atom and $R^2$ represents the group expressed by formula [II], the case where Ar represents 3,5-diphenylphenyl group is excluded since the life of light emission is decreased when Ar represents 3,5-diphenylphenyl group. It is preferable that Ar represents a group in which 2 to 5 benzene rings and more preferably 4 or 5 benzene rings are connected to each other in a manner such that many meta- and ortho-bondings are present so that the molecule has a twisted form. Specific examples are shown in the following.

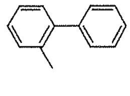

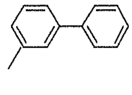

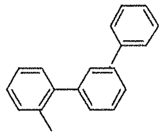
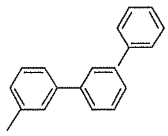
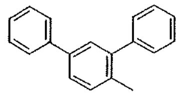

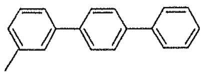
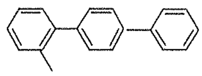
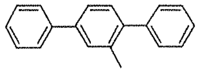

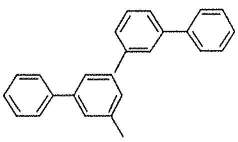
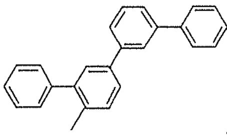
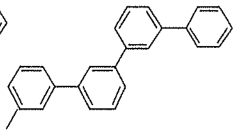
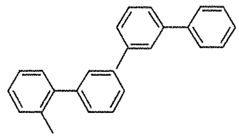

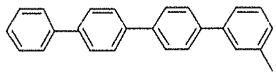
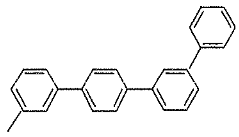
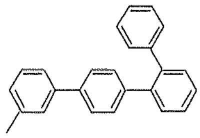

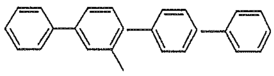
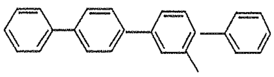
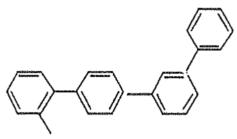
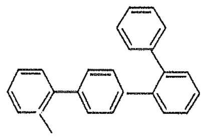

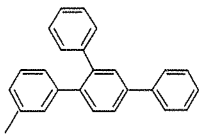
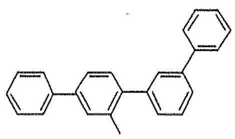
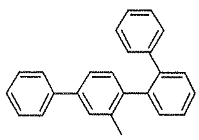

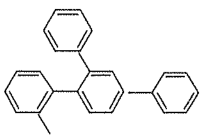
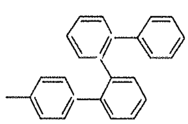
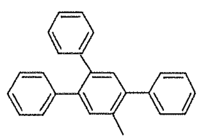
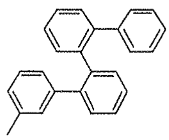

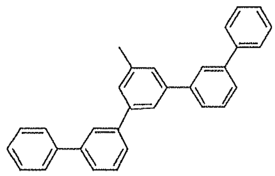

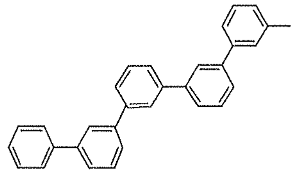

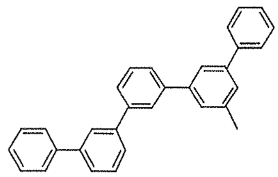

In the above general formula [I], examples of the aryl group having 6 to 50 nuclear carbon atoms which is represented by $R^1$ and $R^2$ include the groups shown as the examples of the group represented by Ar and phenyl group. Phenyl group, groups in which 2 to 5 benzene rings are connected to each other and groups having condensed rings such as naphthyl group, anthranyl group, phenanthryl group, pyrenyl group and coronyl group are preferable.

In the present invention, as the combination of the groups represented by $R^1$ and $R^2$, it is preferable that $R^1$ represents hydrogen atom and $R^2$ represents the group expressed by the above formula [II] or that $R^1$ represents the group expressed by the above formula [II] and $R^2$ represents hydrogen atom. The property of film formation during the formation of the organic EL device using the host material of the present invention is improved when the above combinations are used. In the host material of the present invention, the carbazole derivative represented by the above general formula [I] can be used singly or in combination of two or more.

Specific examples of the carbazole derivative represented by the above general formula [I] are shown in the following.

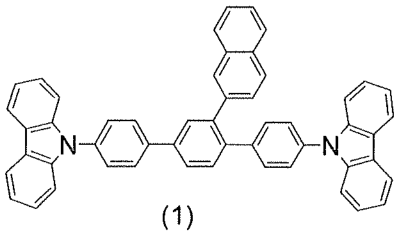

(1)

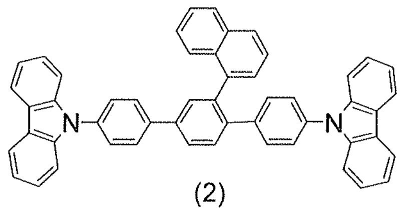

(2)

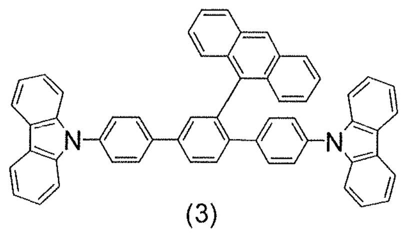

(3)

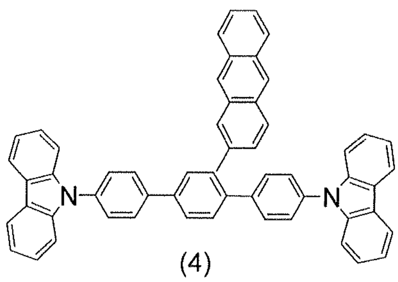

(4)

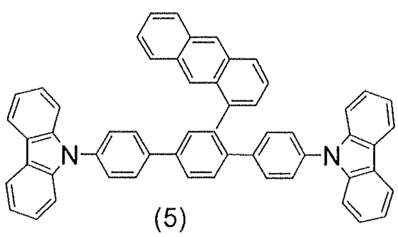

(5)

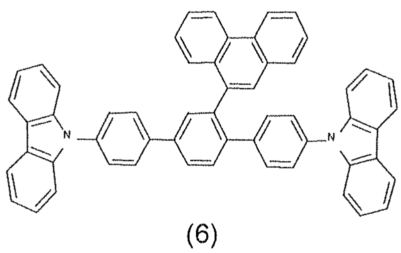

(6)

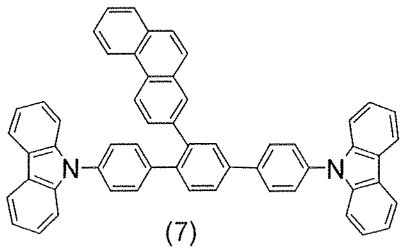

(7)

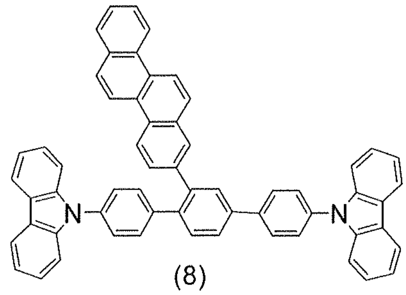

(8)

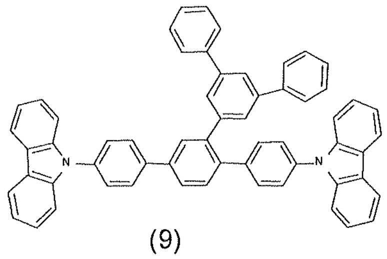

(9)

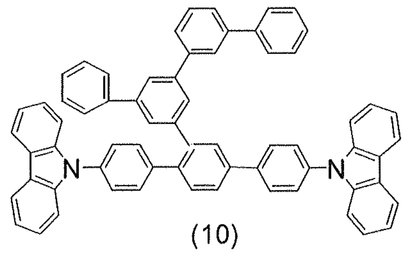

(10)

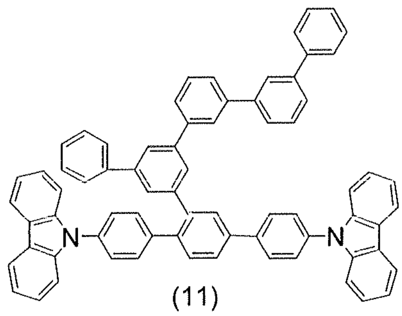

(11)

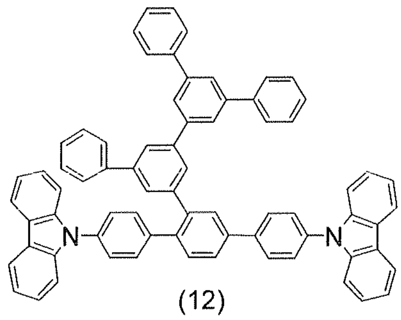

(12)

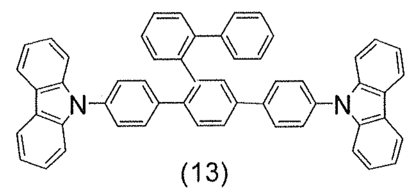

(13)

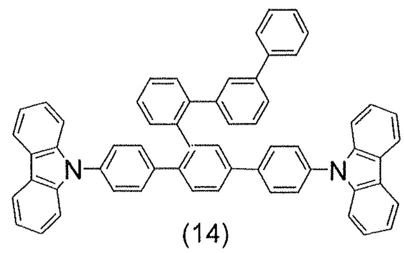

(14)

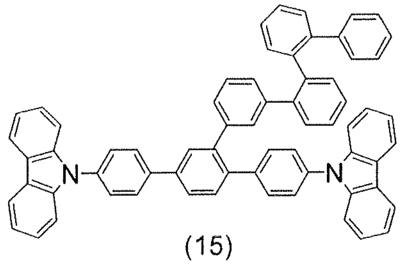

(15)

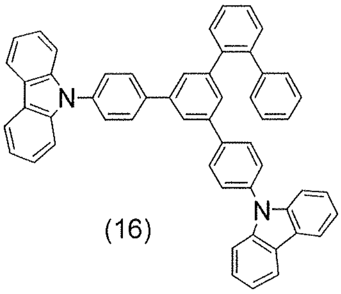

(16)

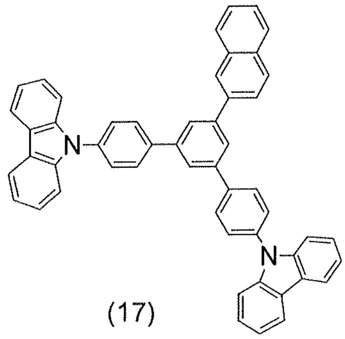

(17)

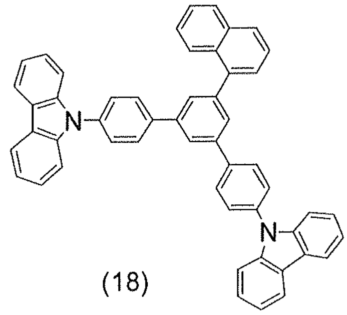

(18)

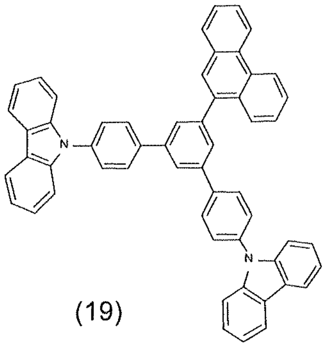

(19)

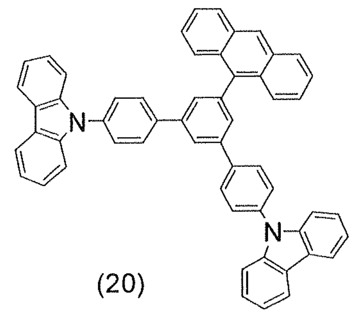

(20)

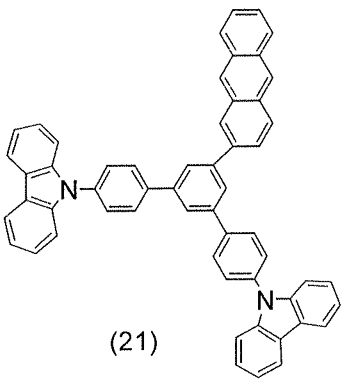

(21)

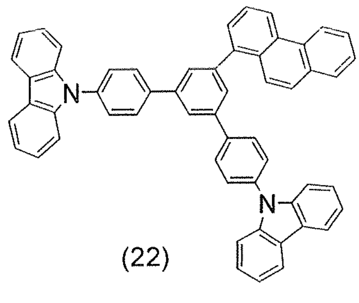

(22)

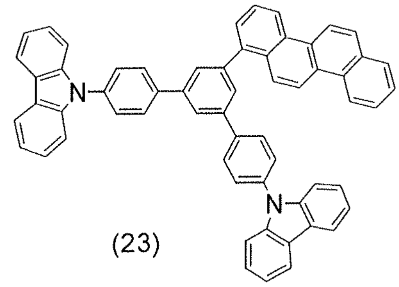

(23)

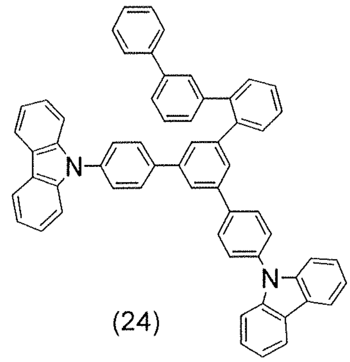

(24)

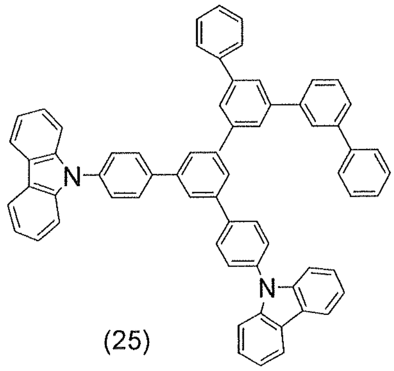

(25)

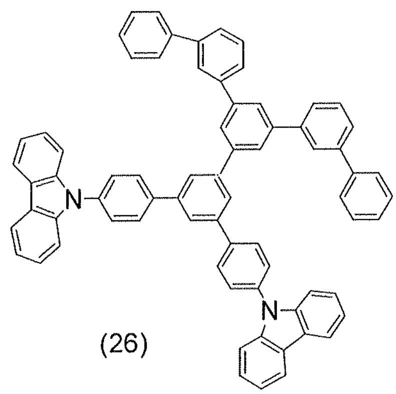

(26)

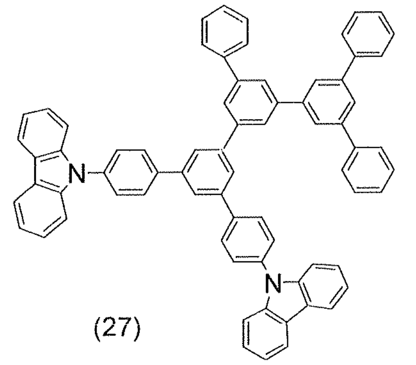

(27)

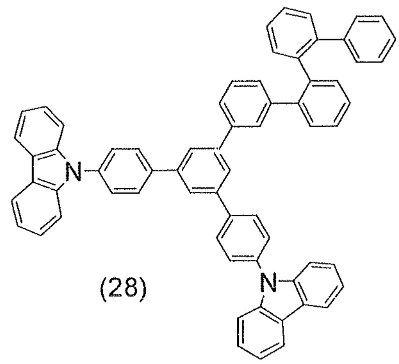

(28)

In the organic device of the present invention, the organic light emitting layer comprises the host material comprising the carbazole derivative represented by the above general formula [I] (occasionally, referred to as carbazole derivative [I], hereinafter) and a dopant. The organic EL device of the present invention has a construction in which one or more organic layers are laminated between the electrodes. Examples of the construction include (an anode / an organic light emitting layer / a cathode), (an anode / a hole injecting or transporting layer / an organic light emitting layer / an electron injecting or transporting layer / a cathode), (an anode / a hole injecting or transporting layer / an organic light emitting layer / a cathode) and (an anode / an organic light emitting layer / an electron injecting or transporting layer / a cathode).

Carbazole derivative [I] (the host material) constituting the organic light emitting layer which is the characteristic portion in the present embodiment is as described above. In the following, mainly, the phosphorescent dopant will be described. Other constituting portions such as the construction of the anode and the cathode and the process for preparation will be described rather simply. As for portions which are not described in the following, a conventional

construction and a conventional process in the field of the organic EL device can be applied.

In the organic EL device of the present invention, the light emitting layer comprises the carbazole derivative represented by general formula [I] as the host material. When carbazole derivative [I] is used as the host material, the triplet excited state of carbazole derivative [I] can be effectively utilized even at the room temperature (20°C) by using the derivative in combination with a phosphorescent dopant which will be described later. In other words, the phenomenon of light emission can be induced by effectively transferring energy from carbazole derivative [I] in the triplet state to the phosphorescent dopant. The host material of the present invention comprises carbazole derivative [I] having at least two skeleton structures of carbazole. When carbazole derivative [I] described above is used as the host material, the glass transition temperature which will be described below and the triplet energy are adjusted easily, and the phosphorescent dopant is mixed easily.

It is preferable that carbazole derivative [I] has a glass transition temperature of 120°C or higher. When the glass transition temperature is 120°C or higher, crystallization is suppressed, and the life is increased when carbazole derivative [I] is used in combination with the phosphorescent dopant. When the glass transition temperature is 120°C or higher, short circuit does not take place in a short time under application of electric current in an environment of high temperatures, and the environment of the use of the organic EL device is not excessively restricted. It is preferable that the glass transition temperature of carbazole derivative [I] is adjusted in the range of 120 to 190°C and more preferably in the range of 140 to 180°C. Carbazole derivative [I] having a glass transition temperature of 190°C or lower is available without excessive restrictions on the type, and the handling of the derivative is facilitated, for example, due to suppressed decomposition during the formation of a film by vapor deposition. Therefore, it is preferable that the glass transition temperature of carbazole derivative [I] is 190°C or lower. The glass transition temperature (Tg) of carbazole derivative [I] can be obtained as the point of the change in the specific heat when the temperature is elevated, for example, at a rate of 10°C/minute using a differential scanning calorimeter (DSC) under circulation of nitrogen gas.

In the organic EL device of the present invention, it is preferable that the relation of E1>E2 is satisfied when E1 represents the triplet energy of carbazole derivative [I] and E2 represents the triplet energy of the phosphorescent dopant in the organic light emitting layer. The triplet excimer of carbazole derivative [I] can be surely utilized even at the room temperature when carbazole derivative [I] and the phosphorescent dopant satisfying the above relation between the triplet energies are used in combination. In other words, the phenomenon of light emission can be induced by surely transferring the energy formed in carbazole derivative [I] in the triplet state to the phosphorescent dopant.

In the organic EL device of the present invention, it is preferable that the phosphorescent dopant is a metal complex compound comprising at least one metal selected from Ir, Ru, Pd, Pt, Os and Re. Energy can be effectively transferred from the triplet excimer of carbazole derivative [I] used as the host material when the phosphorescent dopant is the above metal complex compound. Specific examples of the phosphorescent dopant include metal complex compounds such as tris(2-phenylpyridine)-iridium, tris(2-phenylpyridine)ruthenium, tris(2-phenylpyridine)-palladium, bis(2-phenylpyridine)platinum, tris(2-phenylpyridine)osmium, tris(2-phenylpyridine)rhenium, octaethylplatinumporphyrin, octaphenylplatinumporphyrin, octaethylpalladiumporphyrin and octaphenylpalladiumporphyrin. To achieve more effective transfer of energy and emission of phosphorescent light, metal complex compounds comprising iridium such as tris(2-phenylpyridine)iridium expressed by the following formula are preferable:

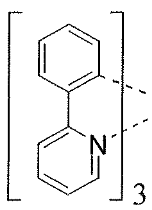

As for the ligand in the metal complex compound, it is preferable that at least one of the ligands in the metal complex compound used as the phosphorescent dopant has at least one skeleton structure selected from skeleton structures of phenylpyridine, bipyridyl and phenanthroline. Energy can be effectively transferred from the triplet excimer of carbazole derivative [I] used as the host material when the above electron-attracting skeleton structure is present in the molecule. Phosphorescent dopants having the skeleton structure of phenylpyridine, among these skeleton structures, such as tris(2-phenylpyridine)iridium are preferable.

It is preferable that the amount of the phosphorescent dopant is in the range of 0.1 to 30 parts by mass based on 100 parts by mass of the carbazole derivative (the host material). When the amount of the phosphorescent dopant is 0.1 part by mass or more, the effect of the addition is exhibited, and energy can be effectively transferred from the triplet excimer of carbazole derivative [I]. When the amount of phosphorescent dopant is 30 part by mass or less, uniform

mixing of the phosphorescent dopant is facilitated, and there is no possibility that the luminance of light emission fluctuates. The amount of the phosphorescent dopant is more preferably in the range of 0.5 to 20 parts by mass and most preferably in the range of 1 to 15 parts by mass.

In the organic EL device of the present invention, it is preferable that a hole injecting layer having a thickness of 5 nm to 5 μm is disposed. By disposing the hole injecting layer, injection of holes into the organic light emitting layer is improved. Therefore, a great luminance of light emission can be obtained, and the driving at a low voltage is made possible. It is preferable that a compound having a mobility of holes of $1\times10^{-6}$ $cm^2/V\cdot sec$ or greater and an ionization energy of 5.5 eV or smaller which are measured under application of an electric field in the range of $1\times10^4$ to $1\times10^6$ V/cm is used.

Examples of the material constituting the hole injecting layer include organic compounds such as porphyrin compounds, aromatic tertiary amine compounds, styrylamine compounds, aromatic dime thy lidine-based compounds and condensed aromatic cyclic compounds, specific examples of which include 4,4-bis[N-(1-naphthyl)-N-phenylamino] biphenyl (referred to as NPD) and 4,4',4"-tris[N-(3-methylphenyl)-N-phenylamino]triphenylamine (referred to as MTDATA). It is also preferable that two or more layers of the above hole injecting materials are laminated, where necessary. When the layers of the device are laminated in the order of the anode / hole injecting material 1 / hole injecting material 2/ ··· / the light emitting layer, it is preferable for decreasing the driving voltage that the ionization energy (Ip) of the hole injecting materials satisfies the relation: Ip(hole injecting material 1)<Ip((hole injecting material 2) ···.

It is preferable that an inorganic compound such as Si of the p-type ad SiC of the p-type is used as the material constituting the hole injecting layer. It is also preferable that an organic semiconductor layer having an electric conductivity of $1\times10^{-10}$ S/cm or greater is disposed between the above hole injecting layer and the anode or between the above hole injecting layer and the organic light emitting layer. Injection of holes into the organic light emitting layer is further improved by disposing the above organic semiconductor layer.

In the organic EL device of the present invention, it is preferable that an electron injecting layer having a thickness of 1 nm to 5 μm is disposed. Injection of electrons into the organic light emitting layer is improved by disposing the electron injecting layer. Therefore, a great luminance of light emission can be obtained, and the driving at a low voltage is made possible. It is preferable that a compound having mobility of electrons of at least $1\times10^{-6}$ $cm^2/V\cdot sec$ and an ionization energy exceeding 5.5 eV which are measured under application of an electric field in the range of $1\times10^4$ to $1\times10^6$ V/cm is used. A compound having an electron affinity of 3.2 eV or smaller is preferable. Specific examples of the material constituting the electron injecting layer include metal complex compounds of 8-hydroxyquinoline (an Al chelate: Alq), derivatives thereof, carbazole derivatives, heterocyclic derivatives having nitrogen, silacyclopentadiene derivatives, borane derivatives and oxadiazole derivatives.

Similarly to the hole barrier layer described below, the applied voltage can be remarkably decreased and the life can be increased when the electron injecting layer comprises an alkali metal.

In the organic EL device of the present invention, it is preferable that a hole barrier layer having a thickness of 1 nm to 5 μm is disposed between the organic light emitting layer and the cathode. The property of enclosing holes into the organic light emitting layer is improved by disposing the hole barrier layer. Therefore, a great luminance of light emission is obtained, and driving under a low voltage is made possible. Examples of the material constituting the hole barrier layer include 2,9-dimethyl-4,7-diphenyl-1,10-phenanthroline and 2,9-diethyl-4,7-diphenyl-1,10-phenanthroline. It is preferable that the hole barrier layer further comprises an alkali metal such as Li and Cs. The voltage is remarkably decreased in driving the organic EL device and the life of the organic EL device can be increased when the alkali metal and the material constituting the hole barrier layer are used in combination for forming the hole barrier layer.

When the hole barrier layer comprises an alkali metal, it is preferable that the content of the alkali metal is adjusted in the range of 0.01 to 30% by mass based on 100% by mass of the entire hole barrier layer. When the content of the alkali metal is 0.01% by mass or greater, the effect of the addition is sufficiently exhibited. When the content is 30% by mass or smaller, dispersion of the alkali metal is made uniform, and the luminance of light emission does not fluctuate. The content of the alkali metal is more preferably in the range of 0.05 to 20% by mass and most preferably in the range of 0.1 to 15% by mass.

Each organic layer in the organic EL device of the present invention can be formed in accordance with any of the dry processes of film formation such as the vacuum vapor deposition process, the sputtering process, the plasma process and the ion plating process and the wet processes of film formation such as the spin coating process, the dipping process, the casting process, the roll coating process, the flow coating process and the ink-jet process.

When a wet process of film formation is used, materials for forming each layer are dissolved or dispersed into a suitable solvent to prepared a light emitting organic solution, and a thin film is formed from the solution or the dispersion. The solvent is not particularly limited. Examples of the solvent include halogenated hydrocarbon-based solvents such as dichloromethane, dichloroethane, chloroform, carbon tetrachloride, tetrachloroethane, trichloroethane, chlorobenzene, dichlorobenzene and chlorotoluene; ether-based solvents such as dibutyl ether, tetrahydrofuran, dioxane and anisole; alcohol-based solvents such as methanol, ethanol, propanol, butanol, pentanol, hexanol, cyclohexanol, methylcellosolve, ethylcellosolve and ethylene glycol; hydrocarbon-based solvents such as benzene, toluene, xylene, ethylbenzene, hexane, octane, decane and tetraline; and ester-based solvents such as ethyl acetate, butyl acetate and amyl acetate. Among these solvents, hydrocarbon-based solvents and ether-based solvents such as toluene and dioxane are preferable. The solvent may be used singly or in combination of two or more. The solvent which can be used is not limited to those described above.

In any of the organic thin film layers, suitable resins and additives may be used to improve the property of film formation and prevent the formation of pin holes in the film. Examples of the resin which can be used include insulating resins such as polystyrene, polycarbonates, polyarylates, polyesters, polyamides, polyurethanes, polysulfones, polymethyl methacrylate, polymethyl acrylate and cellulose; copolymers of the insulating resins; photoconductive resins such as poly-N-vinylcarbazole and polysilanes; and electrically conductive resins such as polythiophene and polypyrrol. Examples of the additive include antioxidants, ultraviolet light absorbents and plasticizers.

In the organic EL device of the present invention, the anode corresponds to the bottom electrode or the common electrode depending on the construction of the organic EL device. It is preferable that a metal, an alloy, an electrically conductive material or a mixture of these materials which has a great work function (for example, 4.0 eV or greater) is used as the anode. Specifically, it is preferable that an electrode material such as indium tin oxide (ITO), indium zinc oxide (IZO), copper iodide (CuI), tin oxide ($SnO_2$), zinc oxide (ZnO), gold, platinum and palladium is used singly or in combination of two or more. Using the electrode material, an anode having a uniform thickness can be formed in accordance with a process which can form a film in the dry condition such as the vacuum vapor deposition process, the sputtering process, the ion plating process, the electron beam vapor deposition process, the chemical vapor deposition (CVD) process, the metal oxide chemical vapor deposition (MOCVD) process and the plasma CVD process.

When the EL light is obtained through the anode, it is necessary that the anode is a transparent electrode. In this case, it is preferable that the transmittance of the EL light is adjusted at 70% or greater using a conductive transparent material such as ITO, IZO, CuI, $SnO_2$ and ZnO. The thickness of the anode is not particularly limited. It is preferable that the thickness of the anode is in the range of 10 to 1,000 nm and more preferably in the range of 10 to 200 nm. When the thickness is in the above range, the uniform distribution of the thickness and the transmittance of the EL light of 70% or greater can be obtained, and the sheet resistivity of the anode can be adjusted at a value of 1,000 Ω/□ or smaller and preferably 100 Ω/□ or smaller.

It is also preferable that the anode (the bottom electrode), the organic light emitting layer and the cathode (the common electrode) are disposed successively and the bottom electrode and the common electrode are disposed in the form of an XY matrix so that light can be emitted from any desired pixel in the light emitting face. When the anode, the organic light emitting layer and the cathode are arranged in the manner described above, various information can be displayed easily by the organic EL device.

The cathode in the organic EL device corresponds to the bottom electrode or the common electrode depending on the construction of the organic EL device. It is preferable that a metal, an alloy, an electrically conductive material, a mixture of these materials or a material comprising these materials which has a small work function (for example, smaller than 4.0 eV) is used as the cathode. Specifically, it is preferable that an electrode material comprising sodium, a sodium-potassium alloy, cesium, magnesium, lithium, a magnesium-silver alloy, aluminum, aluminum oxide, an aluminum-lithium alloy, indium, a rare earth metal, a mixture of a metal described above and a material for the organic EL device or a mixture of a metal described above and a material for the electron injecting layer is used singly or in combination of two or more.

The thickness of the cathode is not particularly limited. It is preferable that the thickness of the cathode is in the range of 10 to 1,000 nm and more preferably in the range of 10 to 200 nm. When light is obtained through the cathode, it is necessary that the cathode is a transparent electrode. In this case, it is preferable that the transmittance of the EL light is adjusted at 70% or greater. It is preferable that, similarly to the anode, the cathode is formed in accordance with a process which can form a film in the dry condition such as the vacuum vapor deposition process and the sputtering process.

In the organic EL device of the present invention, a substrate exhibiting an excellent mechanical strength and a small permeation of water and oxygen is preferable as the supporting substrate. Specific examples include glass plates, metal plates, ceramic plates and plates of plastics (such as polycarbonate resins, acrylic resins, vinyl chloride resins, polyethylene terephthalate resins, polyimide resins, polyester resins, epoxy resins, phenol resins, silicone resins and fluororesins). It is preferable that the supporting substrate comprising the above material is treated for preventing moisture or for providing the hydrophobic property by forming an inorganic film or by coating with a fluororesin so that invasion of water into the organic EL device is prevented. In particular, to prevent invasion of water into the organic EL device, it is preferable that the content of water and the coefficient of permeation of gases of the supporting substrate are decreased. Specifically, it is preferable that the content of water in the supporting substrate is adjusted at a value of 0.0001% by mass or smaller and the coefficient of permeation of gases is adjusted at a value of $1\times10^{-13}$ $cc \cdot cm/cm^2 \cdot sec \cdot cm$ Hg or smaller.

It is possible that a protective layer is formed on the surface or the entire device is protected with a silicone oil or a resin so that stability of the organic EL device obtained in accordance with the present invention to the temperature,

the moisture and the atmosphere is improved.

EXAMPLES

The present invention will be described more specifically with reference to examples in the following. However, the present invention is not limited to the examples. Compounds not shown in the examples of synthesis were synthesized in accordance with a process which can be easily conducted in an analogous manner with the process shown in the examples of synthesis or in accordance with a conventional process.

Example 1 [Synthesis of Compound (1)]

(1) Synthesis of an intermediate compound of synthesis: 2,5-dibromoiodobenzene

In a three-necked flask having an inner volume of 300 ml, 10 g of 2,5-dibromoaniline was dispersed into 70 ml of a dilute hydrochloric acid, and the resultant dispersion was cooled at -10°C. To the cooled dispersion, an aqueous solution obtained by dissolving 3 g of sodium nitrite into 15 ml of water was added dropwise, and the obtained mixture was stirred at -10°C for 40 minutes. In a beaker having an inner volume of 1 liter, 60 g of potassium iodide was dissolved into 180 ml of water, and the solution of a diazonium salt obtained above was added dropwise in small portions under stirring. Nitrogen gas formed during the addition. After the mixture was stirred at the room temperature for 2 hours, 200 ml of methylene chloride was added, and then a small amount of sodium sulfite was added. An organic layer was obtained by extraction, washed with a 10% aqueous solution of sodium sulfite and a saturated solution of sodium chloride, successively, and dried with anhydrous sodium sulfate, and the solvent was removed by distillation. The obtained dark reddish brown oil was purified in accordance with the silica gel column chromatography (the developing solvent: hexane), and 10.47 g of a solid substance having a slightly pink color was obtained. After filtration of the obtained solid substance with methanol, 7.51 g of 2,5-dibromoiodobenzene was obtained as white crystals (the yield: 52%).

(2) Synthesis of an intermediate compound of synthesis: 2-(2,5-dibromophenyl)naphthalene

Into a three-necked flask having an inner volume of 300 ml, 3.70 g (1.1 eq) of 2,5-dibromoiodobenzene, 1.60 g of 2-naphthaleneboronic acid and 0.33 g (0.03 eq) of tetrakis(triphenylphosphine)palladium were placed, and the system was purged with argon. Then, 35 ml of dehydrated toluene and 16 ml (3.43 eq) of a 2 moles/liter aqueous solution of sodium carbonate were added, and the resultant mixture was heated for 8 hours under the refluxing condition. After the obtained mixture was left standing for one night, water and toluene were added. An organic layer was obtained by extraction, washed with water and a saturated solution of sodium chloride, successively, and dried with anhydrous sodium sulfate, and the solvent was removed by distillation. An oil having an orange color obtained as the residue in an amount of 4.8 g was purified in accordance with the silica gel column chromatography (the developing solvent: hexane), and 2.77 g of 2-(2,5-dibromophenyl)naphthalene was obtained as a white solid substance (the yield: 75%).

(3) Synthesis of Compound (1)

Into a three-necked flask having an inner volume of 300 ml, 2.7 g of 2-(2,5-dibromophenyl)naphthalene, 4.49 g (2.1 eq) of N-phenylcarbazoleboronic acid and 0.52 g (0.03 eq) of tetrakis(triphenylphosphine)palladium were placed, and the system was purged with argon. Then, 80 ml of dehydrated toluene and 25.6 ml (3.43 eq) of a 2 moles/liter aqueous solution of sodium carbonate were added, and the resultant mixture was heated for 10 hours under the refluxing condition. After the obtained mixture was left standing for one night, water and toluene were added, and insoluble substances were removed by filtration. The mother liquor was washed with water and a saturated aqueous solution of sodium chloride, successively, and dried with anhydrous sodium sulfate. After the solvent was removed by distillation, a dark brown solid substance obtained as the reside was washed with ethyl acetate, and 4 g of gray crystals were obtained. After purification of the gray crystals in accordance with the silica gel column chromatography (the developing solvent: toluene/hexane=1/1 as the ratio of the amounts by volume), 4.07 g of the object compound (Compound (1)) was obtained as a white solid substance (the yield: 79%).

Example 2 [Synthesis of Compound (10)]

(1) Synthesis of an intermediate compound of synthesis: bromoquaterphenyl

Into a three-necked flask having an inner volume of 300 ml, 5 g of 3-biphenylboronic acid, 3.87 g of 3,5-dibromobiphenyl and 0.87 g (0.03 eq) of tetrakis(triphenylphosphine)palladium were placed, and the system was purged

with argon. Then, 100 ml of dehydrated toluene and 43.3 ml (3.43 eq) of a 2 moles/liter aqueous solution of sodium carbonate were added, and the resultant mixture was heated for 10 hours under the refluxing condition. After the obtained mixture was left standing for one night, an organic layer was obtained by extraction and washed with water and a saturated aqueous solution of sodium chloride, successively. The organic layer was purified in accordance with the silica gel column chromatography (the developing solvent: toluene/hexane=1/1 as the ratio of the amounts by volume), and 7.0 g of bromoquaterphenyl was obtained as a white solid substance (the yield: 72%).

(2) Synthesis of an intermediate compound of synthesis: quaterphenylboronic acid

Into a four-necked flask having an inner volume of 300 ml, 7.0 g of bromoquaterphenyl was placed, and the system was purged with argon. Then, 70 ml of dehydrated toluene and 70 ml of dehydrated ether were added. The resultant mixture was cooled in a dry ice/methanol bath, and a 1.56 moles/liter hexane solution of normal-butyllithium was added dropwise at -40 to -30°C. The mixture was heated at 0°C, and the mixture was cooled again at -63°C immediately after the heating and stirred for 30 minutes. To the cooled mixture, a solution obtained by dissolving 12.5 ml (3 eq) of boronic acid triisopropyl ester into 20 ml of ether was added dropwise, and the resultant mixture was stirred at -63°C for 5 hours. After being left standing for one night, the mixture was acidified with a 5% by mass aqueous solution of hydrochloric acid. An organic layer was obtained by extraction with toluene, washed with water and a saturated aqueous solution of sodium chloride, successively, and dried with anhydrous sodium sulfate. After the solvent was removed by distillation, a white solid substance obtained as the residue was filtered with toluene, and 5.52 g of quaterphenylboronic acid was obtained as white crystals (the yield: 87%).

(3) Synthesis of Compound (10)

Into a three-necked flask having an inner volume of 300 ml, 5.0 g (1.1 eq) of 2,5-dibromoiodobenzene, 4.40 g of quaterphenylboronic acid and 0.44 g (0.03 eq) of tetrakis(triphenylphosphine)palladium were placed, and the system was purged with argon. Then, 70 ml of dehydrated toluene and 20.5 ml (3.43 eq) of a 2 moles/liter aqueous solution of sodium carbonate were added, and the resultant mixture was heated under the refluxing condition for 10 hours. After the obtained mixture was left standing for one night, insoluble substances were removed by filtration. The mother liquor was treated by extraction with toluene, washed with water and a saturated aqueous solution of sodium chloride, successively, and dried with anhydrous sodium sulfate. After the solvent was removed by distillation, 5.15 g of an intermediate compound for Compound (10) was obtained as a solid substance having a cream color (the yield: 76%).

Into a three-necked flask having an inner volume of 300 ml, 5.15 g of the intermediate compound, 5.75 g (2.1 eq) of N-phenylcarbazoleboronic acid and 0.33 g (0.03 eq) of tetrakis(triphenylphosphine)palladium were placed, and the system was purged with argon. Then, 100 ml of dehydrated toluene and 16.3 ml (3.43 eq) of a 2 moles/liter aqueous solution of sodium carbonate were added, and the resultant mixture was heated under the refluxing condition for 10 hours. After the mixture was left standing for one night, the formed precipitates were separated by filtration and washed with water and methanol, successively, and 4.53 g of the object compound (Compound (10)) was obtained as gray crystals (the yield: 55%).

Example 3 [Synthesis of Compound (12)]

In accordance with the same procedures as those conducted in Example 2 except that [1,1',3',1"]terphenyl-5'-boronic acid was used in place of 3-biphenylboronic acid, the object compound (Compound (12)) was obtained.

Example 4 [Synthesis of Compound (16)]

(1) Synthesis of an intermediate compound of synthesis: 5-dibromo-[1,1';2',1"]terphenyl

Into a three-necked flask having an inner volume of 300 ml, 6.42 g (1.1 eq) of 3,5-dibromophenylboronic acid, 4.20 g of 2-iodobiphenyl and 0.52 g (0.03 eq) of tetrakis(triphenylphosphine)palladium were placed, and the system was purged with argon. Then, 45 ml of dehydrated toluene and 22.5 ml (3.0 eq) of a 2 moles/liter aqueous solution of sodium carbonate were added, and the resultant mixture was heated under the refluxing condition for 8 hours. After the mixture was cooled, water and toluene were added. An organic layer was obtained by extraction, washed with water and a saturated aqueous solution of sodium chloride, successively, and dried with anhydrous sodium sulfate, and the solvent was removed by distillation. The residue was purified in accordance with the silica gel column chromatography (the developing solvent: hexane), and 4.83 g of 3,5-dibromo-[1,1';2',1"]terphenyl was obtained as a white solid substance (the yield: 83%).

(2) Synthesis of Compound (16)

Into a three-necked flask having an inner volume of 300 ml, 3.88 g of 3,5-dibromo-[1,1';2',1"]terphenyl, 6.02 g (2.1 eq) of N-phenyl-carbazoleboronic acid and 0.69 g (0.03 eq) of tetrakis(triphenylphosphine)palladium were placed, and the system was purged with argon. Then, 60 ml of dehydrated toluene and 30 ml (3.0 eq) of a 2 moles/liter aqueous solution of sodium carbonate were added, and the resultant mixture was heated under the refluxing condition for 10 hours. After the mixture was cooled, water and toluene were added, and insoluble substances were removed by filtration. The mother liquor was washed with water and a saturated aqueous solution of sodium chloride, successively, and dried with anhydrous sodium sulfate. After the solvent was removed by distillation, a dark brown solid substance obtained as the residue was washed with ethyl acetate, and about 6 g of gray crystals were obtained. The gray crystals were purified in accordance with the silica gel column chromatography (the developing solvent: toluene/hexane=1/1), and 5.13 g of the object compound (Compound (16)) was obtained as a white solid substance (the yield: 72%).

Example 5 [Synthesis of Compound (25)]

(1) Synthesis of an intermediate compound for synthesis of Compound (25)

Into a three-necked flask having an inner volume of 300 ml, 5 g (1.1 eq) of 3,5-dibromoiodobenzene, 4.40 g of quaterphenylboronic acid used for the synthesis of Compound (10) and 0.44 g (0.03 eq) of tetrakis(triphenylphosphine) palladium were placed, and the system was purged with argon. Then, 70 ml of dehydrated toluene and 21.5 ml (3.43 eq) of a 2 moles/liter aqueous solution of sodium carbonate were added, and the resultant mixture was heated under the refluxing condition for 10 hours. After the mixture was left standing for one night, formed insoluble substances were removed by filtration. The mother liquor was treated by extraction with toluene, and the extract was washed with water and a saturated aqueous solution of sodium chloride, successively, and dried with anhydrous sodium sulfate. The solvent was removed by distillation, and 5.15 g of an intermediate compound for synthesis of Compound (25) was obtained as a solid substance having a cream color (the yield: 76%).

(2) Synthesis of Compound (25)

Into a three-necked flask having an inner volume of 300 ml, 5.15 g of the intermediate compound for synthesis of Compound (25), 5.75 g (2.1 eq) of N-phenylcarbazoleboronic acid and 0.33 g (0.03 eq) of tetrakis-(triphenylphosphine) palladium were placed, and the system was purged with argon. Then, 100 ml of dehydrated toluene and 16.3 ml (3.43 eq) of a 2 moles/liter aqueous solution of sodium carbonate were added, and the resultant mixture was heated under the refluxing condition for 10 hours. After the mixture was left standing for one night, formed precipitates were separated by filtration and washed with water and methanol, successively, and 5.02 g of the object compound (Compound (25)) was obtained as gray crystals (the yield: 61%).

Example 6 (Preparation and evaluation of an organic EL device)

(1) Cleaning

A glass substrate (manufactured by GEOMATEC Company) of 25 mm $\times$ 75 mm $\times$ 1.1 mm thickness having an ITO transparent electrode was cleaned by application of ultrasonic wave in isopropyl alcohol for 5 minutes and then by exposure to ozone generated by ultraviolet light for 30 minutes.

(2) Formation of a hole injecting layer

The cleaned glass substrate having the transparent electrode was attached to a substrate holder of a vacuum vapor deposition apparatus. On the ITO transparent electrode, N,N'-bis(N,N'-diphenyl-4-aminophenyl)-N,N-diphenyl-4,4'-diamino-1,1'-biphenyl (referred to as "TPD232", hereinafter) was vapor deposited under the condition of a degree of vacuum of $6.65 \times 10^{-5}$ Pa and a rate of vapor deposition of 0.1 to 0.3 nm/sec, and a first hole injecting layer having a thickness of 60 nm was formed (this layer also had the function of the hole transporting layer). On the formed TPD232 film, 4,4-bis[N-(1-naphthyl)-N-phenylamino]biphenyl (referred to as "NPD", hereinafter) was vapor deposited under the condition of a degree of vacuum of $6.65 \times 10^{-5}$ Pa and a rate of vapor deposition of 0.1 to 0.3 nm/sec, and a second hole injecting layer having a thickness of 20 nm was formed (this layer also had the function of the hole transporting layer).

(3) Formation of an organic light emitting layer

Using the same vacuum vapor deposition apparatus as that used above, Compound (1) obtained above (Tg: 110°C or higher) was vapor deposited on the NPD film formed in the above step under the condition of a degree of vacuum of 6.65 $\times$ $10^{-5}$ Pa and a rate of vapor deposition of 0.1 to 0.3 nm/sec to form an organic light emitting layer having a thickness of 30 nm. At this time, simultaneously with the vapor deposition of Compound (1), tris(2-phenylpyridine) iridium as the phosphorescent dopant was binary vapor deposited (simultaneous vapor deposition). The rate of vapor deposition of the phosphorescent dopant was adjusted so that the amount of the phosphorescent dopant was adjusted at 7% by mass based on 100% by mass of the amount of the entire organic light emitting layer.

(4) Formation of a hole barrier layer

Using the same vacuum vapor deposition apparatus as that used above, a compound expressed by the following formula (BAlq) was vapor deposited on the light emitting layer formed in the above step under the condition of a degree of vacuum of 6.65 $\times$ $10^{-5}$ Pa and a rate of vapor deposition of 0.1 to 0.3 nm/sec, and a hole barrier layer having a thickness of 10 nm was formed.

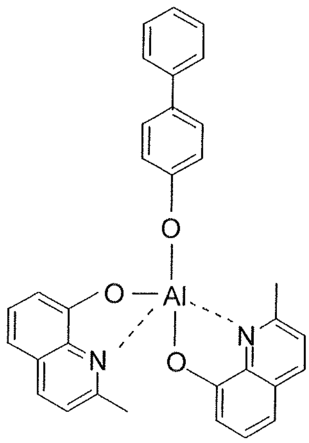

(5) Formation of an electron injecting layer

Using the same vacuum vapor deposition apparatus as that used above, tris(8-quinolinol)aluminum (referred to as Alq, hereinafter) was vapor deposited on the hole barrier layer formed in the above step under the condition of a degree of vacuum of 6.65 $\times$ $10^{-5}$ Pa and a rate of vapor deposition of 0.1 to 0.3 nm/sec, and an electron injecting layer was formed. At this time, Li (the source of lithium: manufactured by SAES GETTERS Company) and Alq were binary vapor deposited (simultaneous vapor deposition) in a manner such that the ratio of the amounts by mole of Li and Alq was 1:1, and an Alq/Li film having a thickness of 20 nm was formed as the electron injecting layer.

(6) Formation of a cathode

Using the same vacuum vapor deposition apparatus as that used above, metallic Al was vapor deposited on the electron injecting layer formed in the above step under the condition of a degree of vacuum of 6.65 $\times$ $10^{-5}$ Pa and a rate of vapor deposition of 0.5 to 1.0 nm/sec, and a cathode having a thickness of 150 nm was formed.

(7) Step of sealing

The obtained organic EL device was placed into a dry box in which dry nitrogen gas was introduced. The face of light emission was covered with a blue glass, and the peripheral portions were treated with an adhesive of the cation curing type TB3102 (manufactured by THREE BOND Co., Ltd.) to seal the organic EL device. Organic EL device (I) was prepared in this manner.

(8) Evaluation of the organic EL device

A direct voltage of 5 V was applied between the anode and the cathode of the obtained organic EL device (I), and it was confirmed that green light having a luminance of emitted light of 120 nit was emitted at an efficiency of light emission of 40 cd/A. The device was driven under a constant current at an initial luminance of 500 nit, and the life test was conducted. As the result, the half life which was the driving time before the luminance decreased to a half of the initial value was found to be 5,300 hours, and it was confirmed the half life was sufficient for practical applications. As the test of heat resistance, the device was examined by passing electric current under the environment of 105°C, and it was confirmed that green light having a sufficient luminance was emitted after the electric current was applied for 500 hours. The obtained results are shown in Table 1.

Example 7

In accordance with the same procedures as those conducted in Examples 6 except that Alq alone was vapor deposited on the light emitting layer to form a film having a thickness of 20 nm and then LiF was vapor deposited to form a film having a thickness of 1 nm in the step of formation of the electron injecting layer, organic EL device (II) was prepared. A direct voltage of 5 V was applied between the anode and the cathode of the obtained organic EL device (II), and it was confirmed that green light having a luminance of emitted light of 100 nit was emitted at an efficiency of light emission of 40 cd/A. The device was driven under a constant current at an initial luminance of 500 nit, and the life test was conducted. As the result, the half life which was the driving time before the luminance decreased to a half of the initial value was found to be 5,500 hours, and it was confirmed the half life was sufficient for practical applications. As the test of heat resistance, the device was examined by passing electric current under the environment of 105°C, and it was confirmed that green light having a sufficient luminance was emitted after the electric current was applied for 500 hours. The obtained results are shown in Table 1.

Examples 8 to 34

Devices were prepared and evaluated in accordance with the same procedures as those conducted in Example 7 except that Compounds (2) to (28) were used as the carbazole derivative in place of Compound (1). The obtained results are shown in Table 1. It was found that the efficiency of light emission, the half life and the heat resistance were all excellent as shown by the results in Table 1.

Table 1

| Example | Compound | Voltage (V) | Luminance of emitted light (nit) | Efficiency of light emission (cd/A) | Color of emitted light | Half life (initial luminance: 500 nit) (hour) | Test of passing current at 105°C (hour) |
|---|---|---|---|---|---|---|---|
| 6 | (1) | 5 | 120 | 40 | green | 5300 | >500 |
| 7 | (1) | 5 | 100 | 40 | green | 5500 | >500 |
| 8 | (2) | 5 | 100 | 40 | green | 4200 | >500 |
| 9 | (3) | 5 | 95 | 42 | green | 3900 | >500 |
| 10 | (4) | 5 | 123 | 39 | green | 3882 | >500 |
| 11 | (5) | 5 | 103 | 41 | green | 5210 | >500 |
| 12 | (6) | 5 | 105 | 45 | green | 5300 | >500 |
| 13 | (7) | 5 | 105 | 44 | green | 5022 | >500 |
| 14 | (8) | 5 | 114 | 39 | green | 5036 | >500 |
| 15 | (9) | 5 | 99 | 38 | green | 4996 | >500 |
| 16 | (10) | 5 | 114 | 39 | green | 4900 | >500 |
| 17 | (11) | 5 | 128 | 41 | green | 5232 | >500 |
| 18 | (12) | 5 | 99.6 | 44 | green | 5147 | >500 |
| 19 | (13) | 5 | 102 | 43 | green | 5234 | >500 |
| 20 | (14) | 5 | 106 | 39 | green | 5500 | >500 |
| 21 | (15) | 5 | 132 | 38 | green | 5267 | >500 |
| 22 | (16) | 5 | 141 | 44 | green | 5600 | >500 |

(continued)

| Example | Compound | Voltage (V) | Luminance of emitted light (nit) | Efficiency of light emission (cd/A) | Color of emitted light | Half life (initial luminance: 500 nit) (hour) | Test of passing current at 105°C (hour) |
|---|---|---|---|---|---|---|---|
| 23 | (17) | 5 | 123 | 42 | green | 5250 | >500 |
| 24 | (18) | 5 | 124 | 43 | green | 5253 | >500 |
| 25 | (19) | 5 | 117 | 43 | green | 5341 | >500 |
| 26 | (20) | 5 | 109 | 41 | green | 5005 | >500 |
| 27 | (21) | 5 | 132 | 39 | green | 5236 | >500 |
| 28 | (22) | 5 | 141 | 56 | green | 4478 | >500 |
| 29 | (23) | 5 | 123 | 41 | green | 5110 | >500 |
| 30 | (24) | 5 | 124 | 40 | green | 4132 | >500 |
| 31 | (25) | 5 | 117 | 50 | green | 6457 | >500 |
| 32 | (26) | 5 | 109 | 43 | green | 4523 | >500 |
| 33 | (27) | 5 | 99 | 38 | green | 5457 | >500 |
| 34 | (28) | 5 | 89 | 40.5 | green | 3100 | >500 |

Example 35

An organic EL device was prepared and evaluated in accordance with the same procedures as those conducted in Example 6 except that metallic Cs which is an alkali metal and Alq were simultaneously vapor deposited in relative amounts by mole of 1:1 when Alq was vapor deposited in the step of formation of a hole barrier layer. As the result, it was confirmed that green light having a luminance of 100 nit was emitted at an efficiency of light emission of 40 cd/A even when a direct voltage of 4.0 V was applied. The device was driven under a constant current at an initial luminance of 500 nit, and the life test was conducted. As the result, the half life was found to be 4,000 hours. As the test of heat resistance, the device was examined by passing electric current under the environment of 85°C, and it was confirmed that green light having a sufficient luminance was emitted after the electric current was applied for 500 hours.

Comparative Example 1

An organic EL device was prepared in accordance with the same procedures as those conducted in Example 7 except that a compound expressed by the following formula:

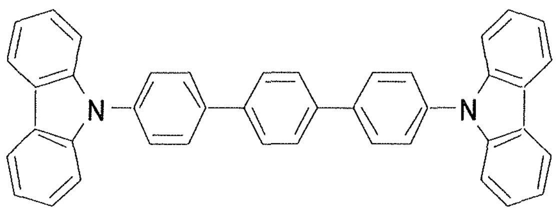

was used in place of Compound (1). When a direct voltage of 5 V was applied to the obtained organic EL device, green light having a luminance of 30 nit was emitted at an efficiency of light emission of 8 cd/A, and it was found that the efficiency of light emission markedly decreased. When the device was examined by passing electric current at a high temperature of 105°C, short circuit took place, and the light emission became impossible after 4 hours. Thus, it was found that the efficiency was small and heat resistance was poor.

Comparative Example 2

An organic EL device was prepared in accordance with the same procedures as those conducted in Example 7 except that a compound expressed by the following formula:

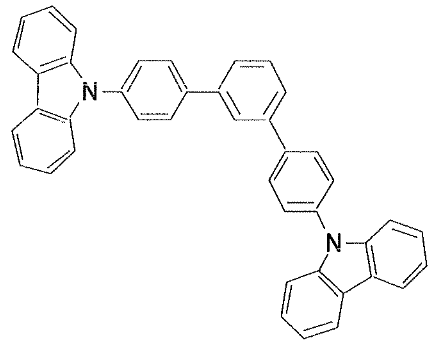

was used in place of Compound (1). When a direct voltage of 5 V was applied to the obtained organic EL device, green light having a luminance of 50 nit was emitted at an efficiency of light emission of 15 cd/A, and it was found that the efficiency of light emission markedly decreased. When the device was examined by passing electric current at a high temperature of 105°C, short circuit took place and the light emission became impossible after 200 hours. Thus, it was found that the efficiency was small and heat resistance was poor.

Comparative Example 3

An organic EL device was prepared in accordance with the same procedures as those conducted in Example 7 except that a compound expressed by the following formula:

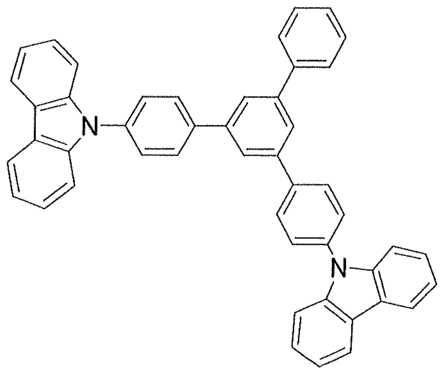

was used in place of Compound (1). When a direct voltage of 5 V was applied to the obtained organic EL device, green light having a luminance of 80 nit was emitted at an efficiency of light emission of 23 cd/A, and it was found that the efficiency of light emission decreased. When the life test was conducted by driving the device under a constant current at an initial luminance of 500 nit, and the half life was found to be 50 hours. When the device was examined by passing electric current at a high temperature of 105°C, short circuit took place and the light emission became impossible after 400 hours. Thus, it was found that the efficiency of light emission was small, the heat resistance was poor, and the life was short.

INDUSTRIAL APPLICABILITY

The organic EL device of the present invention can be advantageously applied to planer light emitting plates for flat panel displays, back lights for copiers, printers and liquid crystal displays, light sources for instruments, display plates and marker lights.

## Claims

**1.** A host material for electroluminescence devices which comprises a carbazole derivative represented by following

general formula [1]:

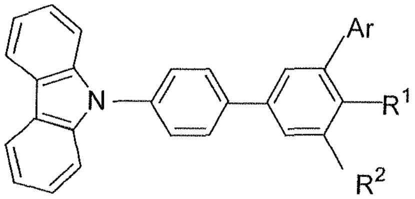

[ I ]

wherein one of $R^1$ and $R^2$ represents a group expressed by following formula [II]:

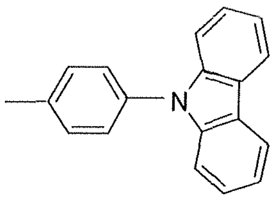

[ II ]

the other of $R^1$ and $R^2$ represents the group expressed by formula [II], hydrogen atom or an aryl group having 6 to 50 nuclear carbon atoms, Ar represents a substituted or unsubstituted aryl group having 6 to 60 nuclear carbon atoms, a case where Ar represents phenyl group, 4-biphenyl group, 4-terphenyl group or 4-quaterphenyl group is excluded and, when $R^1$ represents hydrogen atom and $R^2$ represents the group expressed by formula [II], a case where Ar represents 3,5-diphenylphenyl group is excluded.

**2.** A host material according to Claim 1, wherein $R^1$ represents hydrogen atom and $R^2$ represents the group expressed by formula [II] in general formula [I].

**3.** A host material according to Claim 1, wherein $R^1$ represents the group expressed by formula [II] and $R^2$ represents hydrogen atom in general formula [I].

**4.** A host material according to any one of Claims 2 and 3, wherein Ar in general formula [I] represents a substituted or unsubstituted aromatic cyclic group having condensed 2 to 4 benzene rings.

**5.** A host material according to any one of Claims 2 and 3, wherein Ar in general formula [I] represents a substituted or unsubstituted polyphenyl group in which 2 to 5 phenyl groups are connected to each other.

**6.** A host material according to Claim 5, wherein Ar in general formula [I] represents a substituted or unsubstituted polyphenyl group in which 4 or 5 phenyl groups are connected to each other.

**7.** An organic electroluminescence device which comprises a cathode, an anode and an organic thin film layer which comprises at least one layer comprising at least an organic light emitting layer and is disposed between the cathode and the anode, wherein the organic light emitting layer comprises the host material described in any one of Claims 1 to 6 and a dopant.

**8.** An organic electroluminescence device according to Claim 7, wherein the host material and the dopant exhibit a phosphorescent property and light emitted and obtained by application of an electric current comprises phosphorescent light.

**INTERNATIONAL SEARCH REPORT**

International application No.
PCT/JP2005/000522

A. CLASSIFICATION OF SUBJECT MATTER
Int.Cl[7] H05B33/14, C09K11/06

According to International Patent Classification (IPC) or to both national classification and IPC

B. FIELDS SEARCHED

Minimum documentation searched (classification system followed by classification symbols)
Int.Cl[7] H05B33/00-33/28, C09K11/00-11/89

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
CA(STN)

C. DOCUMENTS CONSIDERED TO BE RELEVANT

| Category* | Citation of document, with indication, where appropriate, of the relevant passages | Relevant to claim No. |
|---|---|---|
| X | JP 2001-313179 A (Mitsubishi Chemical Corp.), 09 November, 2001 (09.11.01), Claims 1 to 3; Par. Nos. [0021] to [0023], [0080] to [0089] (Family: none) | 1-8 |
| X | JP 2003-192691 A (Mitsubishi Chemical Corp.), 09 July, 2003 (09.07.03), Par. Nos. [0078] to [0096] (Family: none) | 1-8 |
| X | JP 2002-8860 A (Mitsubishi Chemical Corp.), 11 January, 2002 (11.01.02), Claims 1 to 5; Par. Nos. [0043], [0077] to [0091] (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 March, 2005 (02.03.05) | 22 March, 2005 (22.03.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2005/000522

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-31371 A (Mitsubishi Chemical Corp.), 31 January, 2003 (31.01.03), Claims 1 to 3; Par. No. [0035] (Family: none) | 1-8 |
| A | JP 2000-21572 A (Mitsubishi Chemical Corp.), 21 January, 2000 (21.01.00), Claim 1 (Family: none) | 1-8 |
| A | JP 2000-186066 A (Minolta Co., Ltd.), 04 July, 2000 (04.07.00), Full text; all drawings (Family: none) | 1-8 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 01072927 A


### Non-patent literature cited in the description


- *Jpn. J. Appl. Phys.,* 1999, vol. 38, L1502